# DEMANDE DE BREVET EUROPEEN

(11) **EP 0 901 167 A1**
(43) Date de publication de la demande: **10.03.1999**
(21) Numéro de dépôt: 98402202.0
(22) Date de dépôt: 07.09.1998
(51) Int. Cl.: H01L 25/11, H01L 23/13, H01L 23/32

(54) **Embase pour diode de puissance d'alternateur de véhicule automobile**

(30) Priorité: 08.09.1997 FR 9711133
(71) Demandeur: VALEO EQUIPEMENTS ELECTRIQUES MOTEUR, 94000 Créteil (FR)
(72) Inventeur: Gautier, Jean, 49124 Saint Barthelemy d'Anjou (FR)
(74) Mandataire: Le Forestier, Eric

(57) **Abrégé**

L'embase (6) pour diode à souder, adaptée à recevoir par soudage un boîtier (8) de diode (4), comprend une partie d'emmanchement (18) adaptée à être emmanchée dans un orifice (34) d'un support (30) suivant un axe (14) de l'embase. L'embase (6) comprend une partie de butée (16) s'étendant en saillie de la partie d'emmanchement (18) suivant une direction radiale à l'axe (14).

## Description

L'invention concerne le montage des diodes définissant un pont redresseur dans un alternateur, notamment pour véhicule automobile.

On connaît d'après le document FR-A-2 737 618 une diode et une embase en forme générale de disque épais. On soude une face d'extrémité de la diode à une face de l'embase. Ensuite, l'embase est emmanchée à force dans un orifice d'un dissipateur d'un alternateur depuis un côté du dissipateur dirigé vers le stator, avec la diode s'étendant finalement d'un côté du dissipateur opposé au stator. Ce dispositif à diode et embase a pour avantage qu'on peut ainsi fixer indifféremment à un même dissipateur ou bien des diodes à emmancher directement, ou bien des diodes à souder, préalablement fixées à une embase. En vue d'un positionnement axial précis de la diode dans l'orifice, la diode doit être introduite depuis un côté du dissipateur dirigé vers le stator. Toutefois, cette manipulation est en général très délicate à effectuer en raison de la configuration de l'alternateur de ce côté du dissipateur.

Un but de l'invention est de faciliter la mise en place de la diode, tout en conservant l'avantage précité.

En vue de la réalisation de ce but, on prévoit selon l'invention une embase pour diode à souder, l'embase étant adaptée à recevoir par soudage un boîtier de diode et comprenant une partie d'emmanchement adaptée à être emmanchée dans un orifice d'un support suivant un axe de l'embase, l'embase comprenant une partie de butée s'étendant en saillie de la partie d'emmanchement suivant une direction radiale à l'axe.

Ainsi, la partie de butée est adaptée à venir en butée contre le support lors de la fixation de la diode. On obtient donc un positionnement axial précis de la diode par rapport au support. Cette embase rend possible un montage de la diode depuis le côté du support opposé au stator. On facilite donc le montage de la diode. En outre, cette embase permet le montage de la diode dans un orifice qui est borgne en direction du stator. De plus, la diode ne risque pas d'être altérée lors du montage.

Avantageusement, la partie de butée présente une face d'appui supérieure orientée en direction opposée à la partie d'emmanchement et définissant une zone d'appui supérieure plane perpendiculaire à l'axe.

Ainsi, l'embase est adaptée pour être en appui contre un outil d'emmanchement.

Avantageusement, l'embase présente une cavité adaptée à recevoir la diode, la face d'appui supérieure s'étendant en saillie de la cavité suivant la direction axiale.

Ainsi, l'ensemble constitué par la diode et l'embase a une dimension axiale peu importante.

Avantageusement, la partie de butée présente une face d'appui inférieure orientée en direction de la partie d'emmanchement et définissant une zone d'appui inférieure plane perpendiculaire à l'axe.

On prévoit également selon l'invention un ensemble comprenant une diode et une embase, la diode comportant un boîtier fixé à l'embase, l'embase étant conforme à l'invention.

Avantageusement, la partie de butée est interposée entre la diode et la partie d'emmanchement suivant la direction axiale.

Ainsi, cette configuration est particulièrement adaptée à un montage depuis le côté du support opposé au stator.

Avantageusement, la partie de butée s'étend en saillie de la diode suivant la direction radiale à l'axe.

On prévoit en outre selon l'invention un alternateur, notamment pour véhicule automobile, comportant un support et un ensemble comprenant une diode et une embase, l'embase étant fixée à la diode et emmanchée dans un orifice du support, l'ensemble étant conforme à l'invention.

Avantageusement, la partie de butée s'étend d'un côté du support opposé à un stator de l'alternateur.

Avantageusement, la partie d'emmanchement est emmanchée dans un orifice borgne du support.

D'autres caractéristiques et avantages de l'invention apparaîtront encore dans la description suivante d'un mode préféré de réalisation donné à titre d'exemple non limitatif. Aux dessins annexés :
- la figure 1 est une vue en élévation avec coupe axiale partielle d'un ensemble selon l'invention comprenant une embase et une diode ; et
- la figure 2 est une vue en coupe de l'ensemble de la figure 1 monté dans un palier d'un alternateur, cette vue montrant l'outil d'emmanchement.

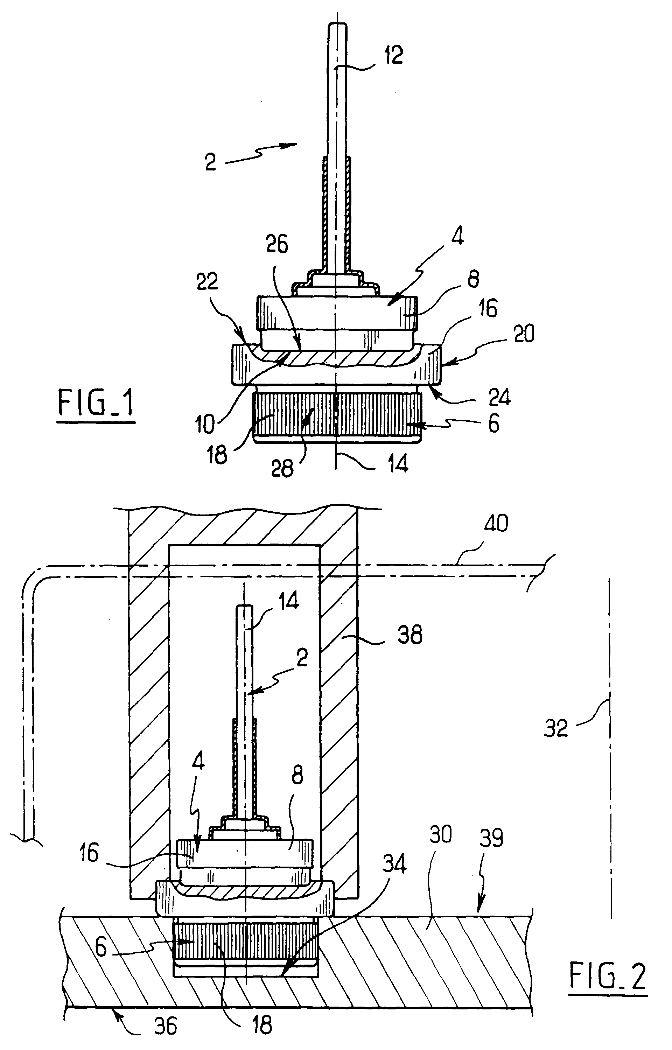

En référence à la figure 1, l'ensemble 2 selon le présent mode de réalisation de l'invention comporte une diode 4 et une embase ou semelle 6. La diode 4 est une diode de puissance à souder d'un type classique. Elle comporte un boîtier métallique 8 renfermant un composant à semi-conducteur. Le boîtier a une forme de révolution autour d'un axe de symétrie et présente une face circulaire plane 10, ici inférieure, constituant une borne de connexion de la diode. La diode présente une autre borne de connexion allongée 12 coaxiale au boîtier 8 et opposée à la face 10 suivant la direction axiale.

L'embase 6 est symétrique de révolution autour d'un axe 14. Elle comporte une partie de butée 16 et une partie d'emmanchement 18 ayant chacune une forme de disque épais. L'embase est réalisée en un métal conducteur de l'électricité. Elle est d'une seule pièce.

La partie de butée 16 présente une face latérale cylindrique 20, une face plane annulaire supérieure 22 et une face plane annulaire inférieure 24, toutes deux contiguës à la face latérale 20. La partie de butée présente au centre de la face supérieure 22 une cavité ayant un fond plat 26 perpendiculaire à l'axe 14. Ainsi, la face supérieure 22 s'étend en saillie du fond 26 suivant la direction de l'axe 14.

La partie d'emmanchement 18 a une face latérale cylindrique 28 munie de cannelures parallèles à l'axe 14. La partie d'emmanchement a un rayon inférieur à celui de la face latérale 20 de la partie de butée. Celle-ci, par conséquent, s'étend en saillie de la partie d'emmanchement suivant la direction radiale à l'axe 14. La diode 4 s'étend dans la cavité, et la face inférieure 10 du boîtier 8 est soudée au fond 26 de la cavité, la diode 4 et l'embase 6 étant coaxiales.

La partie de butée 16 a un rayon supérieur au plus grand rayon de la diode 4, de sorte que la partie de butée s'étend en saillie de la diode suivant la direction radiale à l'axe 14.

En référence à la figure 2, la diode 4 et l'embase 6 sont adaptées à faire partie d'un alternateur de véhicule automobile. L'alternateur comporte un palier arrière 30, opposé à la poulie d'alternateur, s'étendant dans un plan général perpendiculaire à l'axe 32 de l'alternateur dont la direction a été représentée sur la figure 2.

L'alternateur comprend une série de diodes de puissance 4 constituant un pont redresseur et dont fait partie la diode 4 précitée. Chaque diode est associée à une embase selon l'invention. Les ensembles à embase 6 et diode 4 sont fixés au palier arrière 30 qui fait ici office de dissipateur de chaleur. A cette fin, le palier 30 présente des orifices circulaires 34 ayant un axe parallèle à l'axe 32. Les orifices 34 sont par exemple borgnes, en étant obturés d'un côté 36 du palier orienté vers le stator de l'alternateur. Le palier peut alors constituer une cloison étanche.

Pour fixer la diode 4 au palier 30, on soude la diode 4 à l'embase 6. Puis on place l'ensemble sur un outil d'emmanchement adapté 38. Une extrémité de l'outil vient en appui contre la face latérale 20 et la face supérieure 22 de la partie de butée 16. On présente la diode et l'embase depuis un côté 39 du palier opposé au stator, l'embase 6 et l'orifice 34 étant coaxiaux. Au moyen de l'outil 38, on emmanche à force la partie d'emmanchement 16 dans l'orifice 34 jusqu'à mettre la face inférieure 24 de la partie de butée 16 en appui contre le côté 38 du palier. Puis on ôte l'outil. La diode se trouve du côté 39 du palier opposé au stator.

Une fois l'alternateur achevé, la diode 4 s'étend en regard d'un capot externe 40 de l'alternateur, ce capot étant représenté en traits mixtes sur la figure 2.

Bien entendu, on pourra apporter à l'invention de nombreuses modifications sans sortir du cadre de celle-ci. L'orifice 34 du palier pourra être traversant. Le support de l'embase pourra être un dissipateur distinct du palier arrière.

La partie de butée pourra ne pas être circulaire, ni même symétrique par rapport à l'axe de l'embase.

## Revendications

1. Embase (6) pour diode à souder, l'embase étant adaptée à recevoir par soudage un boîtier (8) de diode (4) et comprenant une partie d'emmanchement (18) adaptée à être emmanchée dans un orifice (34) d'un support (30) suivant un axe (14) de l'embase, caractérisée en ce que l'embase (6) comprend une partie de butée (16) s'étendant en saillie de la partie d'emmanchement (18) suivant une direction radiale à l'axe (14).

2. Embase selon la revendication 1, caractérisée en ce que la partie de butée (16) présente une face d'appui supérieure (22) orientée en direction opposée à la partie d'emmanchement (18) et définissant une zone d'appui supérieure plane perpendiculaire à l'axe (14).

3. Embase selon la revendication 2, caractérisée en ce que l'embase (6) présente une cavité adaptée à recevoir la diode (4), la face d'appui supérieure (22) s'étendant en saillie de la cavité suivant la direction axiale (14).

4. Embase selon l'une quelconque des revendications 1 à 3, caractérisée en ce que la partie de butée (16) présente une face d'appui inférieure (24) orientée en direction de la partie d'emmanchement (18) et définissant une zone d'appui inférieure plane perpendiculaire à l'axe (14).

5. Ensemble comprenant une diode (4) et une embase (6), la diode comportant un boîtier (8) fixé à l'embase, caractérisé en ce que l'embase est conforme à l'une des revendications 1 à 4.

6. Ensemble selon la revendication 5, caractérisé en ce que la partie de butée (16) est interposée entre la diode (4) et la partie d'emmanchement (18) suivant la direction axiale (14).

7. Ensemble selon la revendication 5 ou 6, caractérisé en ce que la partie de butée (16) s'étend en saillie de la diode (4) suivant la direction radiale à l'axe (14).

8. Alternateur, notamment pour véhicule automobile, comportant un support (30) et un ensemble comprenant une diode (4) et une embase (6), l'embase étant fixée à la diode et emmanchée dans un orifice (34) du support, caractérisé en ce que l'ensemble est conforme à l'une des revendications 5 à 7.

9. Alternateur selon la revendication 8, caractérisé en ce que la partie de butée (16) s'étend d'un côté du support (30) opposé à un stator de l'alternateur.

10. Alternateur selon la revendication 8 ou 9, caractérisé en ce que la partie d'emmanchement (18) est emmanchée dans un orifice borgne (34) du support (30).
